# EUROPEAN PATENT SPECIFICATION

(11) **EP 0 457 538 B1**
(45) Date of publication and mention of the grant of the patent: **03.08.1994**
(21) Application number: 91304291.7
(22) Date of filing: 14.05.1991
(51) Int. Cl.: C23C 10/04

(54) **Method for coating an article**
Verfahren zum Beschichten eines Werkstücks
Procédé pour revêtir un article

(30) Priority: 14.05.1990 US 523945
(43) Date of publication of application: 21.11.1991
(73) Proprietor: UNITED TECHNOLOGIES CORPORATION, Hartford, CT 06101 (US)
(72) Inventor: Beers, Russell A., West Palm Beach, Florida 33407 (US); Noetzel, Allan A., Palm Beach Gardens, Florida 33418 (US)
(74) Representative: Tomlinson, Kerry John

(56) References cited:
- GB-A- 2 210 387
- US-A- 3 114 961
- PATENT ABSTRACTS OF JAPAN vol. 9, no. 66 (C-271)(1789) March 26, 1985 & JP-A-59 197 558 (MAZDA) November 9, 1984

## Description

The present invention relates to coating articles, and more particularly, to a method for producing gas phase deposition metallic coatings of variable thickness.

The aluminizing process is well known for improving the oxidation and corrosion resistance of many substrates such as alloys containing chromium, iron, nickel, or cobalt, as the major constituent. In particular, aluminide coatings are known to improve the oxidation and corrosion resistance properties of the nickel-and-cobalt-based superalloys which are used in high-temperature environments, such as gas turbine blades and vanes.

In one typical coating process, the article to be coated is embedded in a powder pack containing powdered aluminum, either as the metal, an alloy; or a compound such as with cobalt, a carrier, typically an ammonium or alkali metal halide, and an inert filler such as aluminum oxide. Once embedded, the article is heated to between 1400°F (760°C) and 2200°F (1204°C) depending on the particular coating material, with the thickness of the coating depending on the temperature and the duration of the exposure. The halide acts as a carrier or activator to facilitate the transfer of the aluminum from the powder pack to the exposed surface of the article, where the aluminum is deposited. At the surface of the article, the aluminum and the substrate material interdiffuse to form an aluminide coating, and the halide is freed to transport more aluminum from the powder pack to the article. As the coating thickness increases, the interdiffusion of the aluminum and the substrate decreases, thereby increasing the percent by weight of aluminum in the aluminide coating.

Another coating process, referred to as out-of-pack gas phase deposition of aluminized coatings, is described in U.S. Pat. Nos. 3,486,927 and 4,148,275. This process is similar to the powder pack method except that the article is not embedded in the powder pack. Instead, the aluminum-bearing halide gas is circulated from the powder pack using an inert gas, and into contact with the article to effect an aluminum deposition on the exposed surfaces of the article, producing a coating of substantially uniform thickness thereon.

The out-of-pack process is very useful in applying aluminide coatings to the airfoil section of gas turbine blades. Turbine blades so coated demonstrate significantly greater oxidation and corrosion resistance than uncoated blades, increasing the useful life of the turbine blade. Since the protection from oxidation and corrosion provided by the aluminide coating is directly related to the thickness of that coating, it is desirable to further increase the thickness of the aluminide coating on the airfoil, where that protection is needed most.

However, as the thickness of the aluminide coating increases, the commensurate increase in the percent by weight of aluminum reduces the ductility of the coating. Due to the highly stressed nature of the turbine blade platform region adjacent the high pressure side of the airfoil, the aluminide coating in this region becomes susceptible to fracturing during blade use if the coating thickness exceeds a maximum allowable thickness. The nature of this fracturing is such that cracks in the coating readily propagate into the substrate of the blade platform itself, reducing the integrity, and therefore the useful life, of the turbine blade.

Unfortunately, the aluminide coating thickness necessary to provide the desired oxidation and corrosion resistance on the airfoil is significantly greater than the maximum allowable coating thickness in the blade platform region adjacent the high pressure side of the airfoil. Since the out-of-pack gas deposition method produces a coating of substantially uniform thickness, the aluminide coating thickness on the airfoil has heretofore been limited by the maximum allowable coating thickness in the blade platform region. Consequently, the oxidation and corrosion resistance of gas turbine blades and vanes of the prior art is significantly less than that which could be obtained if the blade platform coating thickness were not a limiting factor.

It is therefore an object of the present invention to provide a method for coating an article with a coating of variable thickness.

Another object of this invention is to provide a method for applying an increased durability metal coating to a turbine blade which does not promote crack formation in the region of the blade platform.

Another object of this invention is to provide a method for coating a turbine blade with a metal coating which is thinner in the blade platform region adjacent the airfoil than the coating on the airfoil.

Viewed from one aspect the present invention provides a method of producing a coating of variable thickness on an exposed surface of an article, said method comprising:
providing shielding means for partially shielding a portion of said exposed surface from a coating-material-bearing gas, said shielding means including an edge which conforms to contours of said exposed surface;
securing said shielding means in fixed, spaced, relation to said shielded portion of said exposed surface to define a shielded region therebetween and a gap between said edge and said exposed surface; and
circulating said gas into contact with said shielded portion and the unshielded portion of said exposed surface to provide said coating thereon;
said circulation of said gas into said shielded region being restricted by said shielding means so that said coating is thinner on said shielded portion than on said unshielded portion.

Viewed from a second aspect, the present invention provides a method of producing a coating of variable thickness on an exposed surface of a turbine blade, said method comprising:
providing a shield means for partially shielding a portion of said exposed surface from a metal-bearing gas, said shield means including an edge which conforms to contours of said exposed surface;
securing said shield means in fixed and spaced relation to said shielded portion of said exposed surface to define a shielded region therebetween and a gap between said edge and said exposed surface;
placing said turbine blade into a coating apparatus;
heating said turbine blade in said coating apparatus to a temperature in excess of 927°C;
introducing said metal-bearing gas into said coating apparatus; and
circulating said metal-bearing gas into contact with said shielded portion and the unshielded portion to provide a metal coating thereon, whereby circulation of said gas into said shielded region is so restricted by said shielding means that said metal-bearing gas deposits a thinner coating on said shielded portion than on said unshielded portion.

Preferred embodiments are claimed in the dependent claims.

The shielding means may be provided for use in coating articles with oxidation and/or corrosion resistant metals such as aluminum, chromium, and the like, by out-of-pack gas phase deposition. The shield restricts circulation of the metal-bearing deposition gas near those shielded surfaces of an article which are shielded by the shield, resulting in a thinner coating on those surfaces. Unshielded surfaces can thereby be coated to the desired thickness while the thickness of the shielded surfaces remains at or below the maximum allowable thickness.

For example, the present invention may be used to coat a gas turbine blade by extending the airfoil section through an aperture in the shield, the aperture being only slightly larger than the outer dimensions of the airfoil, and securing the shield in spaced, proximate relation to the blade platform. During out-of-pack deposition, the turbine blade is exposed to the circulating metal-bearing gas until a coating of the desired thickness builds up on the airfoil. Since the shield restricts circulation of the metal-bearing gas in the blade platform region, the coating on the platform is significantly thinner and more ductile than the coating on the airfoil. The resulting variable thickness coating exhibits the desired oxidation and/or corrosion resistance on the airfoil while providing the ductility necessary on the blade platform region to avoid crack formation therein. Thus, a turbine blade may be coated with an aluminum coating so that the aluminum content in the blade platform region is significantly less than the aluminum content of the coating on the airfoil.

The foregoing and other features and advantages of the present invention will become more apparent from the following description and accompanying drawings of an embodiment given by way of example only.
Figure 1 is a perspective view of a turbine blade with a shield device according to a first embodiment of the present invention attached; and
Figure 2 is a perspective view of a turbine blade with a shield according to an alterative embodiment of the present invention attached.

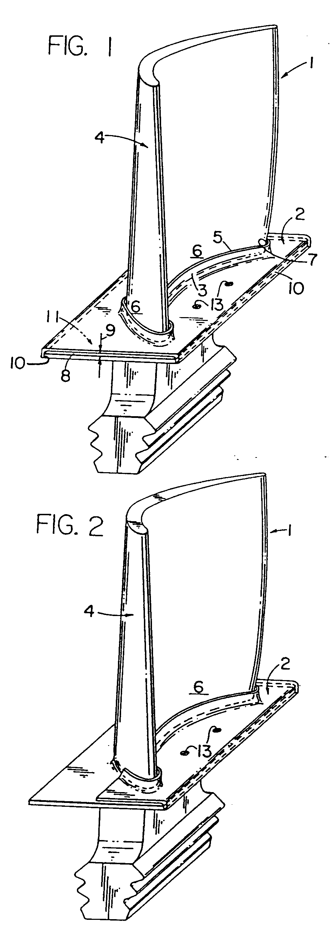

Shown in Fig. 1 is a turbine blade 1 with a shield 2 in accordance with the invention attached thereto. The shield 2 is preferably constructed of a 0.025 inch (0.64 mm) thick sheet of Hastelloy X, a trademark of Union Carbide Corporation, Danbury, Connecticut, for an alloy containing by weight approximately 48.3% nickel, 22.0% chromium, 1.5% cobalt, 0.10% carbon, 18.5% iron, 9.0% molybdenum, and 0.6% tungsten. Although Hastelloy X is the preferred material for construction of the shield 2, it will be apparent to those skilled in the art that other materials which can withstand the gas phase deposition temperatures may be used as well. The shield 2 includes an aperture 3 through which the airfoil section 4 of the turbine blade 1 extends. The edge 5 of the shield 2 is shaped to conform to the contours of the airfoil surface 6. The aperture 3 is slightly larger than is necessary to receive the airfoil 4, and the airfoil 4 is centered within the aperture 3 so that the edge 5 of the aperture 3 is in spaced relation to the airfoil surface 6. A gap 7 is thus defined between the airfoil surface 6 and the edge 5 of the aperture 3, the gap 7 being substantially uniform along the length of the edge 5.

The shield 2 is secured in fixed, spaced relation to the platform surface 8, so that the separation 9 between the shielded portion of the platform surface 8 and the shield 2 is approximately 0.022 inches (0.56 mm). Although a separation 9 of 0.022 inches is preferred for the present example, a larger or smaller separation 9 may be used depending on whether a thicker or thinner coating, respectively, is desired. As those skilled in the art will readily appreciate, since the percent by weight of aluminum increases with increasing aluminide coating thickness, increasing the separation 9 increases the percent by weight of aluminum in the aluminide coating on that portion of the turbine blade 1 shielded by the shield 2.

To secure the shield 2 in fixed relation to the turbine blade 1, the shield 2 is preferably tack welded to edges 10 of the platform 11 which will eventually be machined off. However, the shield 2 may be secured to any structure which can support the shield in fixed relation to the platform surface 8. Additionally, holes 13 approximately 0.025 inches (0.64 mm) in diameter may be strategically placed in the shield 2 to prevent bare spots in the coating on the platform surface 8 due to excessive shielding.

Although the shield 2 as shown in Fig. 1 shields substantially all of the blade platform surface, it may be desirable to provide a reduced thickness coating on only the high pressure side of the blade platform. Fig. 2 shows an embodiment of the shield 2 of the present invention which shields only the high pressure side of blade platform, leaving the low pressure side of the blade platform exposed. This embodiment is similar to the embodiment shown in Fig. 1, except that the low pressure side of the shield has been removed. Those skilled in the art will recognize that the embodiment shown in Fig. 1 could be modified to include perforations on the low pressure side of the shield 2, or the gap 7 between the edge 3 and the low pressure side of the airfoil surface 6 could be substantially increased, either of which would reduce the shielding effect of the low pressure side of the shield 2, producing a thicker coating thereon.

The shield 2 may be formed by cutting a blank of Hastelloy X to form an aperture 3 nearly the shape of the airfoil surface 6 contours, and drilling the holes 13. The blank may then be stamped by known sheet metal processes to form the final shape of the shield 2. A shim of 0.022 inches (0.56 mm) may then be placed on the platform surface 8 between the shield 2 and the platform surface 8 to provide the desired separation 9. With the shim in place, the shield 2 may be tack welded to at least one edge 10 of the platform 11, and the shim removed.

Alternatively, the shield 2 may be made by casting, or any other appropriate metal-forming process known in the art. Likewise, the shield 2 may be part of a reusable mechanical mask which is secured to the turbine blade 1 by means which do not require the destruction of the shield 2 after one use. Once the shield 2 is secured in fixed relation to the turbine blade 1, both may be placed in a coating apparatus heated in excess of 1700°F (927°C), and aluminum deposition gas circulated therein.

Test results show that the aluminide coating on a turbine blade is 0.5 to 1.2 mils (0.01 to 0.03 mm) thinner on the shielded section of the platform 11 than on the unshielded portions of the turbine blade which have an aluminide coating thickness of 3.5 mils (0.09mm). In addition to being significantly thinner than the coating on the airfoil 4, the coating on the platform surface 8 has a typical aluminum content of approximately 18% by weight as compared to approximately 23% by weight aluminum content in the airfoil section coating. As with many aluminides, a higher aluminum content equates with a lower level of ductility, and a brittle coating may be more susceptible to cracking. Therefore, lower aluminum content of the thinner platform coating provides the oxidation and corrosion resistance desired on the blade platform, while at the same time providing sufficient ductility to withstand operational stresses without promoting crack growth in the blade platform substrate.

The shielded portion of the surface may have a minimum aluminum content by weight which is not more than 85% of the maximum aluminum content by weight of the unshielded portion.

Although this invention has been shown and described with respect to detailed embodiments thereof, it will be understood by those skilled in the art that various changes in form and detail thereof may be made without departing from the claimed invention.

## Claims

1. A method of producing a coating of variable thickness on an exposed surface of an article, said method comprising:
providing shielding means for partially shielding a portion of said exposed surface from a coating-material-bearing gas, said shielding means including an edge which conforms to contours of said exposed surface;
securing said shielding means in fixed, spaced, relation to said shielded portion of said exposed surface to define a shielded region therebetween and a gap between said edge and said exposed surface; and
circulating said gas into contact with said shielded portion and the unshielded portion of said exposed surface to provide said coating thereon;
said circulation of said gas into said shielded region being restricted by said shielding means so that said coating is thinner on said shielded portion than on said unshielded portion.

2. The method of claim 1, wherein the step of securing the shielding means includes the step of securing said shielding means to said article prior to circulating said gas into said shielded region.

3. The method of claim 1 or 2, wherein said coating is metallic and said gas is a metal-bearing gas.

4. The method of claim 3, further comprising using aluminum bearing gas and spacing said shield from said shielded portion such that the restriction of the circulation of the gas causes the unshielded portion of said coating to have a maximum aluminum content by weight and said shielded portion to have a minimum aluminum content by weight, wherein said minimum aluminum content is not more than 85% of said maximum aluminum content.

5. The method of claim 3 or 4, wherein said gas is an aluminum-bearing gas and said shielding means is spaced from said shielded portion a distance sufficient to produce an aluminum content by weight of approximately 23% in said coating on said unshielded portion, and an aluminum content by weight of approximately 18% in said coating on said shielded portion.

6. A method of producing a coating of variable thickness on an exposed surface of a turbine blade, said method comprising:
providing a shield means for partially shielding a portion of said exposed surface from a metal-bearing gas, said shield means including an edge which conforms to contours of said exposed surface;
securing said shield means in fixed and spaced relation to said shielded portion of said exposed surface to define a shielded region therebetween and a gap between said edge and said exposed surface;
placing said turbine blade into a coating apparatus;
heating said turbine blade in said coating apparatus to a temperature in excess of 927°C;
introducing said metal-bearing gas into said coating apparatus; and
circulating said metal-bearing gas into contact with said shielded portion and the unshielded portion to provide a metal coating thereon, whereby circulation of said gas into said shielded region is so restricted by said shield means that said metal-bearing gas deposits a thinner coating on said shielded portion than on said unshielded portion.

7. The method of claim 6, wherein the step of securing said shield means comprises securing said shield means to said turbine blade prior to placing said turbine blade in said coating apparatus.

8. The method of claim 6 or 7, further comprising using aluminum-bearing gas as the metal-bearing gas, and spacing said shield from said shielded portion a distance sufficient to produce an aluminum content by weight of approximately 23% in said coating on said unshielded portion, and an aluminum content by weight of approximately 18% in said coating on said shielded portion.

## Patentansprüche

1. Verfahren zum Herstellen einer Beschichtung unterschiedlicher Dicke auf einer ausgesetzten Oberfläche eines Gegenstandes, aufweisend:
Vorsehen einer Abschirmeinrichtung zum teilweisen Abschirmen eines Teils der ausgesetzten Oberfläche gegen ein Beschichtungsmaterial-haltiges Gas, wobei die Abschirmeinrichtung einen Rand aufweist, der den Konturen der ausgesetzten Oberfläche angepaßt ist;
Befestigen der Abschirmeinrichtung in einer festen, beabstandeten Relation zu dem abgeschirmten Teil der ausgesetzten Oberfläche, um einen abgeschirmten Bereich dazwischen und einen Spalt zwischen dem Rand und der ausgesetzten Oberfläche zu definieren; und
Zirkulieren des Gases in Kontakt mit dem abgeschirmten Teil und dem nicht abgeschirmten Teil der ausgesetzten Oberfläche, um darauf die Beschichtung zu bilden;
wobei die Zirkulation des Gases in den abgeschirmten Bereich durch die Abschirmeinrichtung eingeschränkt ist, so daß die Beschichtung auf dem abgeschirmten Teil dünner ist als auf dem nicht abgeschirmten Teil.

2. Verfahren nach Anspruch 1, bei dem der Schritt des Befestigene der Abschirmeinrichtung den Schritt des Befestigens der Abschirmeinrichtung an dem Gegenstand vor dom Zirkulieren des Gases in den abgeschirmten Bereich aufweist.

3. Verfahren nach Anspruch 1 oder 2, bei dem die Beschichtung metallisch ist und das Gas ein metallhaltiges Gas ist.

4. Verfahren nach Anspruch 3, das außerdem aufweist:
Verwenden eines aluminiumhaltigen Gases und Beabstanden der Abschirmung von dem abgeschirmten Teil so, daß die Zirkulationsbeschränkung des Gases bewirkt, daß der nicht abgeschirmte Teil der Beschichtung einen maximalen Aluminiumgewichtsanteil und der abgeschirmte Teil einen minimalen Aluminiumgewichtsanteil aufweist, wobei der minimale Aluminiumanteil nicht größer ist als 85 % des maximalen Aluminiumanteils.

5. Verfahren nach Anspruch 3 oder 4, bei dem das Gas ein aluminiumhaltiges Gas ist und die Abschirmeinrichtung von dem abgeschirmten Teil einen Abstand beabstandet ist, der ausreicht, einen Aluminiumgewichtsanteil von ungefähr 23 % in der Beschichtung auf dem nicht abgeschirmten Teil zu erzeugen und einen Aluminiumgewichtsanteil von ungefähr 18 % in der Beschichtung auf dem abgeschirmten Teil zu erzeugen.

6. Verfahren zum Herstellen einer Beschichtung unterschiedlicher Dicke auf einer ausgesetzten Oberfläche einer Turbinenschaufel, wobei das Verfahren aufweist:
Vorsehen einer Abschirmeinrichtung zum teilweisen Abschirmen eines Teils der ausgesetzten Oberfläche gegen ein metallhaltiges Gas, wobei die Abschirmeinrichtung einen Rand aufweist, der den Konturen der ausgesetzten Oberfläche angepaßt ist;
Befestigen der Abschirmeinrichtung in fester und beabstandeter Relation zu dem abgeschirmten Teil der ausgesetzten Oberfläche, um einen abgeschirmten Bereich dazwischen und einen Spalt zwischen dem Rand und der ausgesetzten Oberfläche zu definieren;
Anordnen der Turbinenschaufel in einer Beschichtungsvorrichtung;
Aufheizen der Turbinenschaurel in der Beschichtungsvorrichtung auf eine Temperatur über 927°C;
Einleiten des metallhaltigen Gases in die Beschichtungsvorrichtung; und
Zirkulieren des metallhaltigen Gases in Kontakt mit dem abgeschirmten Teil und dem nicht abgeschirmten Teil, um darauf eine Metallbeschichtung zu bilden, wobei die Zirkulation des Gases in den abgeschirmten Bereich durch die Abschirmeinrichtung so eingeschränkt ist, daß das metallhaltige Gas auf dem abgeschirmten Teil eine dünnere Beschichtung abscheidet als auf dem nicht abgeschirmten Teil.

7. Verfahren nach Anspruch 6, bei dem der Schritt des Befestigens der Abschirmeinrichtung aufweist:
Befestigen der Abschirmeinrichtung an der Turbinenschaufel vor dem Anordnen der Turbinenschaufel in der Beschichtungsvorrichtung.

8. Verfahren nach Anspruch 6 oder 7, außerdem aufweisend:
Verwenden eines aluminiumhaltigen Gases als metallhaltiges Gas und Beabstanden der Abschirmung von dem abgeschirmten Teil um einen Abstand, der ausreicht, einen Aluminiumgewichtsanteil von ungefähr 23 % in der Beschichtung auf dem nicht abgeschirmten Teil zu erzeugen und einen Aluminiumgewichtsanteil von ungefähr 18 % in der Beschichtung auf dem abgeschirmten Teil zu erzeugen.

## Revendications

1. Procédé de production d'un revêtement d'épaisseur variable sur une surface exposée d'un article, ce procédé comprenant :
le fait d'apporter un moyen de protection pour protéger partiellement une partie de cette surface exposée d'un gaz portant une matière de revêtement, ce moyen de protection comportant un bord qui se conforme aux contours de cette surface exposée ;
le fait de fixer ce moyen de protection dans une relation fixe, espacée, par rapport à cette partie protégée de cette surface exposée, pour définir entre elles une région protégée et un intervalle entre ce bord et cette surface exposée ; et
le fait de faire circuler ce gaz au contact de cette partie protégée et de la partie non protégée de cette surface exposée pour apporter ce revêtement sur celles-ci ;
cette circulation de ce gaz dans cette région protégée étant limitée par ce moyen de protection, de telle sorte que ce revêtement est plus fin sur cette partie protégée que sur cette partie non protégée.

2. Procédé selon la revendication 1, dans lequel l'étape de fixation du moyen de protection comprend l'étape de fixation de ce moyen de protection à cet article, avant de faire circuler ce gaz dans cette région protégée.

3. Procédé selon la revendication 1 ou 2, dans lequel ce revêtement est métallique et dans lequel ce gaz est un gaz contenant un métal.

4. Procédé selon la revendication 3, comprenant, en outre, l'utilisation d'un gaz contenant de l'aluminium et l'espacement de cet écran protecteur de cette partie protégée de telle sorte que la restriction de la circulation du gaz a pour effet que la partie non protégée de ce revêtement présente la teneur pondérale maximale en aluminium, et que cette partie protégée a la teneur pondérale minimale en aluminium, dans lequel cette teneur minima en aluminium n'est pas supérieure à 85 % de cette teneur maximale en aluminium.

5. Procédé selon la revendication 3 ou 4, dans lequel ce gaz est un-gaz contenant de l'aluminium et ce moyen de protection est espacé de cette partie protégée d'une distance suffisante pour donner une teneur pondérale en aluminium d'environ 23 % dans ce revêtement sur cette partie non protégée, et une teneur pondérale en aluminium d'environ 18 % dans ce revêtement sur cette partie protégée.

6. Procédé de production d'un revêtement d'épaisseur variable sur une surface exposée d'une ailette de turbine, ce procédé comprenant :
le fait d'apporter un moyen de protection pour protéger partiellement une partie de cette surface exposée d'un gaz portant un métal, ce moyen de protection comportant un bord qui se conforme aux contours de cette surface exposée ;
le fait de fixer ce moyen de protection dans une relation fixe et espacée, avec cette partie protégée de cette surface exposée, pour définir entre elles une région protégée et un intervalle entre ce bord et cette surface exposée ;
le fait de placer cette ailette de turbine dans un appareil de revêtement ;
le fait de chauffer cette ailette de turbine dans cet appareil de revêtement à une température supérieure à 927 °C ;
le fait d'introduire ce gaz portant un métal dans cet appareil de revêtement ; et
le fait de faire circuler ce gaz portant un métal au contact de cette partie protégée et de la partie non protégée pour réaliser sur celles-ci un revêtement de métal, la circulation de ce gaz dans cette région protégée étant limitée par ce moyen de protection, de telle sorte que ce gaz portant un métal dépose un revêtement plus fin sur cette partie protégée que sur cette partie non protégée.

7. Procédé selon la revendication 6, dans lequel l'étape de fixation de cet écran protecteur, comprend le fait de fixer cet écran protecteur sur cette ailette de turbine, avant de placer cette ailette de turbine dans cet appareil de revêtement.

8. Procédé selon la revendication 6 ou 7, comprenant, en outre, l'utilisation d'un gaz contenant de l'aluminium comme gaz contenant un métal, et le fait d'espacer cet écran protecteur de cette partie protégée d'une distance suffisante pour produire une teneur pondérale en aluminium d'environ 23 % dans ce revêtement sur cette partie non protégée, et une teneur pondérale en aluminium d'environ 18 % dans ce revêtement sur cette partie protégée.
